# EUROPEAN PATENT APPLICATION

(11) **EP 0 633 607 A1**
(43) Date of publication of application: **11.01.1995**
(21) Application number: 94109690.1
(22) Date of filing: 23.06.1994
(51) Int. Cl.: H01L 21/60, H01L 23/488, H05K 3/34

(54) **Optical semiconductor device to optical substrate attachment method**

(30) Priority: 06.07.1993 US 85808
(71) Applicant: MOTOROLA INC., Schaumburg, Illinois 60196 (US)
(72) Inventor: Galloway, David, Tempe, Arizona 85282 (US); Subrahmanyan,, Scottsdale, Arizona 85250 (US); Kuo, Shun-Meen, Chandler, Arizona 85226 (US); Lebby, Michael S., Junction, Arizona 85219 (US)
(74) Representative: Hudson, Peter David

(57) **Abstract**

A method of attaching a semiconductor die (10) to a substrate (26) includes forming a metallic bump (17) on the semiconductor die (10) to extend a distance (20) from the semiconductor die (10). A conductive epoxy bump (18) is then formed on the metallic bump (17). The conductive epoxy bump (18) is placed in contact with the substrate (26). The conductive epoxy bump (18) is rapidly cured to maintain precise alignment between the semiconductor die (10) and the substrate (26).

## Description

### Background of the Invention

The present invention relates, in general, to methods for attaching a semiconductor die to an intermediate substrate, and more particularly, to a novel flip-chip method of attaching a semiconductor die to an intermediate substrate.

A variety of so called flip-chip bonding or attachment techniques have been used to attach a semiconductor die to intermediate substrates such as printed circuit boards. Two of these prior art flip-chip techniques are commonly known as solder ball and epoxy bump attach. One problem associated with these prior art flip-chip techniques is the inability to maintain precise alignment, less than a 2 micron variation, between elements on the semiconductor die and elements on the intermediate substrate. Such precise alignment is particularly important in attaching an optical semiconductor device to an intermediate substrate having corresponding optical elements. Precise alignment typically requires die to substrate planarity, that is, the variation from parallel alignment, of less than approximately 0.1 percent.

Solder ball attachment techniques utilize a ball of solder between a semiconductor die and the intermediate substrate. Attachment is accomplished by melting or liquefying the solder ball then cooling the solder ball to facilitate adhesion to both the semiconductor die and the substrate. The liquid solder ball's surface tension generally moves the die thereby destroying precise alignment made between elements on the semiconductor die and elements on the intermediate substrate as the die was placed on the substrate.

Epoxy bump attachment techniques result in bumps having unequal heights. One example of such an epoxy bump attachment method is described in U.S. Patent No. 5,074,947 issued to Estes et al on December 24, 1991. In order to achieve the desired planarity of less than approximately 0.1 percent , height variation among the epoxy bumps must be less than approximately 2 to 3 microns. Because the height variation typically is greater than 3 microns, die to substrate planarity varies more than 0.1 percent thereby preventing precise alignment between semiconductor die elements and substrate elements. An additional problem with the prior epoxy bumps is the minimum bump spacing that can be achieved is only approximately 250 microns. It is desirable to have bump spacings of less than 250 microns.

Solder ball attachment techniques also result in bumps of unequal height. The height of each solder ball is determined by the amount of solder used to form the ball. Because it is difficult to control the amount of solder used, the planarity resulting from solder ball attachment techniques is generally greater than the desired approximately 0.1 per cent planarity.

Accordingly, it is desirable to have a flip-chip method of attaching a semiconductor die to a substrate that provides a planarity of less than approximately 0.1 percent, that has bumps which vary in height less than approximately 2 to 3 microns, and that maintains precise alignment, less than a 2 micron variation, between elements on a semiconductor die and elements on a substrate.

### Summary of the Invention

Briefly stated, the present invention includes a method of attaching a semiconductor die to a substrate. A metallic bump is formed on the semiconductor die to extend a distance from the semiconductor die. A conductive epoxy bump is then formed on the metallic bump.

### Brief Description of the Drawings

FIG. 1 illustrates an enlarged cross-sectional portion of a semiconductor die at a stage in forming a composite bump in accordance with the present invention; and
FIG. 2 illustrates an enlarged cross-sectional portion of a semiconductor die attached to an intermediate substrate in accordance with the present invention.

### Detailed Description of the Drawings

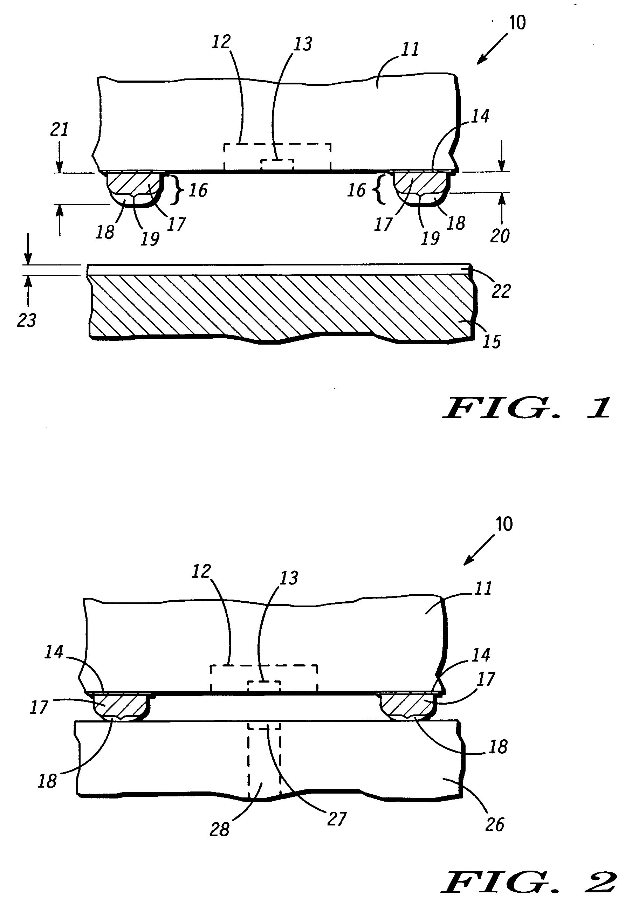

FIG. 1 illustrates an enlarged cross-sectional portion of a semiconductor die 10 at a stage in forming a composite bump 16 on die 10. Die 10 includes a substrate 11 which can be silicon, gallium arsenide, or other type of semiconductor material. Die 10 generally includes an active semiconductor device 12 which is illustrated by a dashed line. As will be seen hereinafter, the precise alignment achieved by using bump 16 is particularly important in maintaining precise alignment between an optical semiconductor die and an optical substrate. Consequently, the preferred embodiment of device 12 is either an optical emitter or an optical detector having an optical port 13. Die 10 typically includes a plurality of attachment or bonding pads 14 that provide a means to electrically connect active semiconductor devices on die 10, such as device 12, to external circuits.

Composite bump 16 is formed on pad 14 to attach die 10 to an intermediate substrate and to form external electrical connections to die 10. Composite bump 16 is formed in two portions, a metallic bump 17 and a conductive polymer or conductive epoxy bump 18, which result in a composite bump height 21. Metallic bump 17 is formed as a solid metal or laminated metal that flexes in order to absorb stresses resulting from thermal mismatches between die 10 and a substrate to which die 10 is attached. Metallic bump 17 has a height 20 that is easily controlled thereby improving planarity between device 10 and the substrate. Additionally, the material of bump 17 remains a solid at the temperatures to which die 10 is exposed during subsequent attachment to a substrate, and during other operations. For example, bump 17 may be a plated bump formed from copper, gold, or other suitable conductive material. Additionally, bump 17 can be a laminated or multi-layer, typically gold plated, bump or other similar type of metallic bump that is often used for tape automated bonding (TAB). One example of a suitable bump is described in U.S. Patent No. 4,927,505 issued to Sharma et al on May 22, 1990. Furthermore, bump 17 can be formed by shaping a gold bonding wire while attaching the bonding wire to pad 14. One method of shaping a gold bonding wire into bump 17 is by thermosonically attaching a doped gold bonding wire to pad 14, then breaking off the bonding wire at the neck, that is, between the bonding wire and the mound formed as the bonding wire is compressed against pad 14. Generally, such doped gold bonding wires consistently break at the same point on the neck as described in United States patent No. 4,771,066 issued to Goldenberg et al on January 5, 1988 and also in United States patent No. 4,442,967 issued to van de Pas et al on April 17, 1984. After shaping, a portion of the neck often is left as a small protrusion 19 extending from bump 17. In the preferred embodiment, bump 17 is formed by shaping an approximately 25 micron diameter, doped gold bonding wire while attaching the bonding wire to pad 14. In this preferred embodiment, bump 17 has a diameter of approximately 70 to 90 microns, a height of approximately twenty-five to fifty microns, and a height variation among all bumps 17 of less than approximately two microns. Also in this preferred embodiment, a model 1482XQ bonding machine manufactured by K & S Inc. of Willow Grove Pa. is used to perform the bonding. The bonding machine is modified to accommodate bonding to a semiconductor wafer thereby facilitating performing such bonding on all die in a semiconductor wafer instead of singulated die.

Conductive epoxy bump 18 is applied onto bump 17. The material used for bump 18 has sufficient viscosity and particle loading to support the weight of die 10. The material of bump 18 also adheres well to the material of bump 17 and to the material of the substrate to which die 10 is to be attached. In the preferred embodiment, the material used for bump 18 has a viscosity greater than 100 Kilo centi-poise and a particle loading of between 80 to 90 percent. Also in this preferred embodiment, the material of bump 18 has conductive flakes having a size between approximately 4 and 12 microns because conductive flakes provide a lower resistivity than provided by conductive spherical particles. Generally, the material has a resistivity of less than approximately 400 micro. ohm-cm. In the preferred embodiment, the material has a resistivity of less than approximately 50 micro. ohm-cm.

In order to provide precise alignment between die 10 and a substrate, it is important to have a consistent size among all bumps 18 on die 10. In the preferred embodiment, bumps 18 are formed by creating a sheet of conductive epoxy or conductive epoxy sheet 22 having a height 23 that is approximately one-half of height 20. Sheet 22 is formed by dispensing an amount of conductive epoxy material onto a smooth planar plate 15, such as a stainless steel plate. An edge that has a controlled height above the stainless steel plate is drawn across the material to form the material into sheet 22. Such a technique is often referred to as "blading" by those skilled in the art. An example of "blading" is described in the user's manual of a model 3100H die bonder manufactured by Assembly Technologies, Inc. of Horsham, Pa.

Die 10 is lowered so that bumps 17 are immersed within sheet 22 until the conductive epoxy material of sheet 22 wets to bumps 17. Because height 23 is approximately one-half of height 20, material from sheet 22 does not contact or adhere to the surface of die 10. Thereafter, die 10 is slowly raised to withdraw bumps 17 from sheet 22 so that surface tension forms the material remaining on bumps 17 into bump 18. The resulting bump 18 has a height approximately one-half the height of bump 17, and provides a height variation among each composite bump 16 of less than approximately two to three microns.

FIG. 2 is an enlarged cross-section illustrating a portion of die 10 attached to a portion of an intermediate substrate 26. Substrate 26 can be one of a variety of different types of substrates utilized to interconnect die 10 to other semiconductor die or other devices. For example, substrate 26 could be a printed circuit board, a ceramic substrate with metallic interconnects, or a semiconductor substrate that includes metal interconnects and other semiconductor devices. In the preferred embodiment, substrate 26 is an optical substrate formed by a printed circuit board having an optical port 27 that is a part of an optical medium or optical waveguide 28. In this preferred embodiment, it is important to have optical port 27 precisely aligned with optical port 13 in order to maximize the coupling efficiency between optical ports 13 and 27. Also in the preferred embodiment, die 10 and substrate 26 include a plurality of ports 13 and 27, respectively, although only one is shown for simplicity of explanation.

During assembly, a vision system (not shown) is utilized to individually locate ports 13 and 27. This typically is accomplished while die 10 is separated from substrate 26 by a large distance to allow room for the vision system to acquire an image of each of die 10 and substrate 26. Using the location identification provided by the vision system, a robotic arm (not shown) moves die 10 until ports 13 and 27 are aligned to within less than two microns. Die 10 is then placed on substrate 26 so that the alignment is maintained. Then, conductive epoxy bumps 18 are rapidly cured thereby insuring that die 10 does not move and that the precise alignment between ports 13 and 27 is maintained. In the preferred embodiment, bumps 18 are cured at a temperature greater than 125 degrees Celsius (°C) for approximately five seconds to one minute.

By now, it should be appreciated that there has been provided a novel method of aligning and attaching a semiconductor die to an intermediate substrate. By using a composite bump consisting of a metallic bump covered with conductive epoxy bump, a composite bump height variation of less than approximately 2 to 3 microns and a planarity of less than approximately 0.1 percent can be maintained. The metallic bump flexes to accommodate different thermal expansions between the semiconductor die and the substrate, thereby increasing the attachment reliability. The epoxy portion of the bump provides for rapid curing without movement thereby maintaining alignment between the semiconductor die elements and the substrate elements.

## Claims

1. A method of attaching a semiconductor die to a substrate comprising:
providing a semiconductor die (10);
providing a substrate (26);
forming a metallic bump (17) on the semiconductor die (10) wherein the metallic bump (17) extends a first distance (20) from the semiconductor die (10); and
forming a conductive polymer bump (18) on the metallic bump (17).

2. The method of claim 1 further including placing the conductive polymer bump (18) in contact with the substrate (26), and rapidly curing the conductive polymer bump (18).

3. The method of claim 2 wherein:
rapidly curing the conductive polymer bump (18) includes maintaining alignment between a point on the semiconductor die (10) and a point on the substrate (26) while adhering the polymer bump (18) to the substrate (26).

4. A method of attaching an optical semiconductor device (12) to a substrate (26) comprising:
providing an optical semiconductor die (10) having a first optical port (13);
providing a substrate (26);
forming a metallic bump (17) on the optical semiconductor die (10) wherein the metallic bump (17) has a first height (20) from the optical semiconductor die (10);
forming a sheet (22) of conductive epoxy having a second height (23) that is approximately one-half the first height (20);
forming a conductive epoxy bump (18) on the metallic bump (17) by inserting the metallic bump (17) into the sheet (22) of conductive epoxy;
aligning the first optical port (13) with a point on the substrate;
placing the conductive epoxy bump (18) on the substrate (26); and
rapidly curing the conductive epoxy bump (18) to maintain alignment between the first optical port (13) and the point on the substrate (26) while adhering the conductive epoxy bump (18) to the substrate (26).

5. The method of claim 4 wherein forming the conductive epoxy bump (18) on the metallic bump (17) includes maintaining the metallic bump (17) in the sheet (22) of conductive epoxy until wetting occurs; and
further including slowly removing the metallic bump (17) from the sheet (22) of conductive epoxy so that surface tension forms the conductive epoxy bump (18).

6. The method of claim 4 wherein forming the metallic bump (17) includes shaping a doped gold bonding wire.

7. A method of aligning an optical semiconductor device (12) to an optical substrate (26) comprising:
providing an optical semiconductor die (10) having a bonding pad (14) on a surface of the optical semiconductor die (10) and a first optical port (13);
providing an optical substrate (26) having an optical medium (28) and a second optical port (27);
forming a metallic bump (17) on the bonding pad (14) by shaping a doped gold bonding wire while attaching the doped gold bonding wire to the bonding pad wherein the metallic bump (17) has a first height (20);
forming a sheet (22) of conductive epoxy having a second height (23) that is approximately one-half the first height (20);
inserting the metallic bump (17) into the sheet (22) of conductive epoxy by moving the surface of the optical semiconductor die (10) toward the sheet (22) of conductive epoxy;
maintaining the metallic bump (17) in the sheet (22) of conductive epoxy until the conductive epoxy wets to the metallic bump (17);
removing the metallic bump (17) from the sheet (22) of conductive epoxy so that surface tension of the conductive epoxy forms a conductive epoxy bump (18) on the metallic bump (17);
aligning the first optical port (13) with the second optical port (27);
placing the conductive epoxy bump (18) on the substrate (26) while maintaining alignment between the first optical port (13) with the second optical port (27); and
rapidly curing the conductive epoxy to maintain alignment between the first optical port (13) and the second optical port (27) while adhering the conductive epoxy to the substrate (26).

8. The method of claim 7 wherein forming the metallic bump (17) on the bonding pad (14) by shaping the doped gold bonding wire includes attaching the doped gold bonding wire having a diameter of approximately 25 microns to the bonding pad (14), and breaking the gold bonding wire near a neck of the bonding wire to metallic bump interface.

9. The method of claim 7 wherein:
forming the metallic bump (17) includes forming the metallic bump (17) to have a diameter of approximately 70 to 90 microns and a height (20) of approximately 25 to 50 microns; and
rapidly curing the conductive epoxy bump (18) includes curing the conductive epoxy bump (18) at a temperature of approximately 125°C for approximately five seconds to one minute

10. The method of claim 7 wherein forming the sheet (22) of conductive epoxy includes using a conductive epoxy material having a viscosity of at least approximately 100 Kilo centi-poise and having a particle loading of approximately 80 to 90 per cent.
